Europäisches Patentamt

(19) European Patent Office

Office européen des brevets

(11) Publication number: **0 016 231**
**B1**

(12) **EUROPEAN PATENT SPECIFICATION**

(45) Date of publication of patent specification: **15.06.83**

(21) Application number: **79901043.4**

(22) Date of filing: **28.08.79**

(86) International application number:
**PCT/JP79/00228**

(87) International publication number:
**WO 80/00520 20.03.80 Gazette 80/6**

(51) Int. Cl.³: **H 05 K 3/00,** H 05 K 3/10,
H 05 K 3/12, H 01 L 49/02

(54) **METHOD OF MAKING THICK FILM FINE PATTERNS.**

(30) Priority: **31.08.78 JP 106665/78**

(43) Date of publication of application:
**01.10.80 Bulletin 80/20**

(45) Publication of the grant of the patent:
**15.06.83 Bulletin 83/24**

(84) Designated Contracting States:
**DE FR GB**

(56) References cited:
**JP - A - 52 093 963**
**JP - A - 52 137 667**

**Clyde F. Coombo, Jr. (Printed Circuits Handbook) (1967) McGraw-Hill Book Co. P. (4—11)—(4—25)**
**ELECTRONIC DESIGN, vol. 27, no. 13, June 21, 1979, Rochelle Park, US "From Japan: optical transformer. photo process for large-scale hybrids"**

(73) Proprietor: **FUJITSU LIMITED**
**1015, Kamikodanaka Nakahara-ku**
**Kawasaki-shi Kanagawa 211 (JP)**

(72) Inventor: **WATANABE, Yutaka**
**1598-14, Nogaya-cho Machida-shi**
**Tokyo 194-01 (JP)**
Inventor: **MATSUO, Hisayasu**
**Room 330, No4-Ichigao Ryo 2737, Eda-cho**
**Midori-ku Yokohama-shi (JP)**

(74) Representative: **Bedggood, Guy Stuart et al,**
**Haseltine Lake & Co. Hazlitt House 28**
**Southampton Buildings Chancery Lane**
**London WC2A 1AT (GB)**

# Method of making thick film fine patterns

This invention relates to an improvement in a thick film fine pattern forming method where the desired circuit pattern is formed by coating thick film paste for circuit formation on an insulating film substrate, in more detail, to a method of economically and easily forming a thick film fine pattern having a very fine circuit which is particularly effective when used in thick film hybrid IC's and plasma display units, etc.

Hybrid IC's are categorized as either thick film hybrid IC's or thin film hybrid IC's in accordance with the different methods of film formation used in their production.

In the case of a thick film hybrid IC, a circuitry film is formed on a substrate by using paste for forming various kinds of circuit elements. Various kinds of paste are on the market; namely, conductor paste, which can be obtained by mixing noble metal powder, such as Au, Ag, Au-Pt etc. powder, and glass frit and dispersing such mixture in organic resin binder solution; resistance paste, which can be obtained by mixing powder of Ag-Pd or ruthenium oxide, having a large resistance value, and glass frit, and dispersing such mixture in organic resin binder solution; dielectric paste, which can be obtained by mixing ferrodielectric material, such as titanic acid or zircon acid etc., powder and glass frit and dispersing such mixture in organic resin binder solution; or insulating material paste, which can be obtained by dispersing glass frit in organic resin binder solution.

Currently, mixtures of various kinds of pastes are available from a variety of paste makers. The generally-used pastes for circuit formation certainly include organic resin binder solution in order to provide a certain degree of viscosity. Such binder solution is a solution obtained by dissolving organic resin such as methyl-cellulose, ethyl-cellulose etc. into organic solvent, of high boiling point, such as butyl-carbitol or butyl-carbitol-acetate etc.

In an existing method of thick film circuit pattern formation, a conductor pattern, a resistor pattern and a capacitor pattern of the desired form are obtained by coating paste as mentioned above on an alumina ceramic insulated substrate by screen printing. Thereafter, wiring conductors, resistors and capacitors are formed as film elements on the insulating substrate by baking the circuit pattern.

On the other hand, in the case of a thin film hybrid IC, a thin film forming system such as a sputtering system or an evaporation system is used. Thus, metal such as Au, Al, Ni-Cr, Ta etc. is first evaporated, according to the system used, and coated onto an insulated substrate over its entire surface. Thereafter, an unwanted portion of such metallic thin film is eliminated by a photo-etching process, and wiring conductors, resistors and capacitors of desired form can be formed on the insulated substrate by patterning.

The system of formation of paste film on the insulated substrate in the abovementioned thick film forming method is very economical as compared with the film forming system used in the thin film forming method and requires a shorter period of time for film formation with simple control during formation.

Thus, the thick film forming method has an advantage in that low cost circuit substrates can be produced on a mass-production line. On the other hand, it has a disadvantage in that a fine pattern such as can be obtained by the thin film forming method cannot be obtained by the thick film forming method.

Namely, the existing thick film forming method as explained above is limited by screen mesh size because a circuit pattern is formed by screen printing and in general, in practice, pattern width is limited, at its most fine, to 200 $\mu$m. As a result, it has been considered difficult to obtain a fine pattern with a pattern width of 50 $\mu$m, such as can be obtained by thin film forming method.

For this reason, conventional hybrid IC's have been produced by the thin film forming method, even if some of them having high density electrical circuitry do not require formation of electrical circuits with high accuracy from the electrical viewpoint. Every substrate with a thin film pattern is very expensive.

In a special example of a thick film forming method, photo-etching technology is employed in order to obtain a fine circuit pattern. In such a method, a paste containing photo-sensitive material is coated on an insulated substrate and dried out. Then, this paste film itself is exposed and developed in order to form a desired circuit pattern. Thereafter, the circuit pattern is baked and thereby a circuit board can be obtained.

However, this method is expensive because the paste is obtained by a special production method. Moreover, it has a problem in that various film elements cannot be obtained because the kinds of paste on the market are limited to pastes such as Au conductive paste or Ag conductive paste etc. Application of such special pastes complicates handling and it is difficult to obtain a homogeneous fine pattern with excellent reproduceability, and examples of practical application seem to be very rare.

Moreover in a plasma display having a structure in which two glass substrate sheets respectively providing an X direction electrode pattern and a Y direction electrode pattern are stacked together and a gap between the glass substrates is filled with a rare gas such as neon or helium etc., an economic self-shift type panel requires a pattern as fine as 60 $\mu$m because the X, Y electrode patterns for display must be formed in a complicated pattern, such as a meander format pattern. Thus, pattern formation has been accomplished by means of the abovementioned thin film forming method, resulting in an increase in cost.

United States Patent No. 4,119,480 (to which Japanese patent document JP—A—52 137 667 corresponds) discloses a method of manufacturing a thick-film circuit device. In such a method a thick-film circuit forming past including an organic solvent is coated over a substrate and then dried. A photosensitive resin layer is deposited on the layer of paste. The photosensitive resin layer may be water soluble. The photosensitive resin layer is then exposed and developed. Thereafter, thick-film circuit forming paste is selectively removed, for example by a spraying process using an organic solvent, and remaining paste is then fired.

It is an object of the present invention to offer, considering the aforementioned background, a method of forming a thick film fine pattern which can economically and easily realise a fine pattern with high density with a pattern width such as is obtained by a thin film forming method.

It is another object of the present invention to offer a method of forming a thick film fine pattern which realises formation of a fine pattern by the use of ordinary paste which is marketed for the purpose of forming thick film circuit patterns, rather than by the use of a specially produced paste as mentioned above.

It is a further object of the present invention to offer a method of forming a thick film fine pattern which ensures formation of a fine pattern with high accuracy and excellent reproduceability.

Moreover, it is an object of the present invention to provide a method of forming a thick film fine pattern which does not easily allow pattern deviation or deformation during a spraying process for selective removal of thick-film circuit forming paste using an organic solvent, and thereby allows for the formation of a finer pattern.

According to the present invention there is provided a method of forming a thick film fine pattern, in which an oleaginous thick film paste including an organic solvent is used for circuit formation and in which an aqueous photo-resist not including an organic solvent is used for patterning the paste, the photo-resist being coated on the paste surface, after coating of the paste on a substrate and drying of the paste, and exposed and developed, thereafter uncovered paste being removed by spraying with organic solvent, and remaining paste baked, characterised in that a bonding agent is coated onto the substrate and the paste is coated on the substrate over the bonding agent.

According to the present invention, there are also provided thick film hybrid IC's produced by a thick film fine pattern forming method embodying this invention.

According to the present invention, there is still further provided a plasma display in which discharge electrode pattern groups are produced by a thick film fine pattern forming method embodying this invention.

Reference is made, by way of example, to the accompanying drawings, in which:—

Figure 1(A) to (E) are respective cross-sectional views illustrating the sequence of processes in a thick film fine pattern forming method, which is not in accordance with the present invention.

Figure 2 to Figure 5 are characteristic diagrams indicating relationships between drying temperature and drying period for various kinds of pastes for circuit formation, and

Figure 6 is a cross-sectional view illustrating an embodiment of this invention.

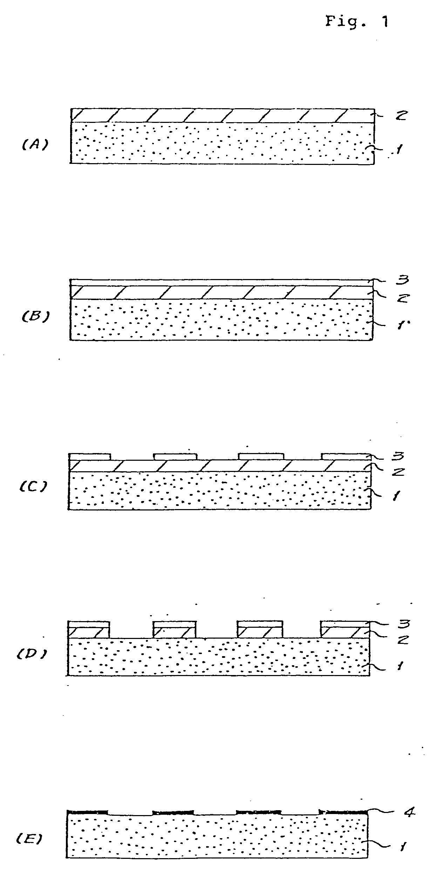

In the forming method of Figure 1, as shown in Figure 1(A), first of all, an ordinary circuit formation paste as aforementioned (conductive paste, resistance paste, dielectric paste, insulation paste etc.) is homogeneously coated to a thickness of 8 to 30 $\mu$m by a printing method on the entire surface of a circuit formation area of an insulated substrate 1. Thus, a paste film 2 can be formed, and it is hardened by drying at a temperature of 60°C to 160°C.

Then, as shown in Figure 1(B), a water-soluble photo-resist film 3 not including an organic solvent is coated and formed on the entire surface of the paste film 2 of Figure 1(A).

Succeedingly, in order to eliminate unwanted areas of film 3 on unwanted parts of film 2, parts of the photo-resist film 3 on the paste film 2 are eliminated and exposed as shown in Figure 1(C) by exposing the photo-resist film 3 using a not-illustrated mask and developing the photo-resist film by dipping into aqueous solution.

In this condition, mixed powder is removed by dissolving the organic resin binder of the paste film 2 at exposed areas of film 2 using an organic solvent, and then patterning is performed for the paste film 2 as shown in Figure 1(D).

Thereafter, when the paste film 2 of Figure 1(D) is baked (for example at 800°C to 920°C), the organic resin binder of the paste film 2 is burned and vaporized as illustrated in Figure 1(E). Thus, the mixed powder is melted and fixed on the insulated substrate 1. In addition, it grows into a circuit film 4 having specified electrical characteristics, and thereby a thick film fine pattern is formed.

The photo-resist film 3 in Figure 1(D) can be baked at the baking temperature and can also be removed in the baking process illustrated in Figure 1(E). Here, a process for previously removing such photoresist film in advance, by dipping into water before baking may be included.

Then, a practical manufacturing example by a pattern forming method as illustrated in Figure 1 will be explained.

First, concerning the drying temperature of circuit formation paste film 2, the inventors of the invention of this application have conducted experiments with various pastes which are currently used for forming thick film hybrid IC's and have found an adequate drying temperature condition.

This condition is provided at a temperature higher than that at which the paste film is hardened to such a degree as not to be deformed by external force applied when the photo-resist is coated on, but lower than that at which organic binder included in the paste hardens so firmly that it might not dissolve in the organic solvent. More practically, adequate drying temperature should be selected in the range 60°C to 160°C, while the drying period should be in the range 10 to 60 minutes.

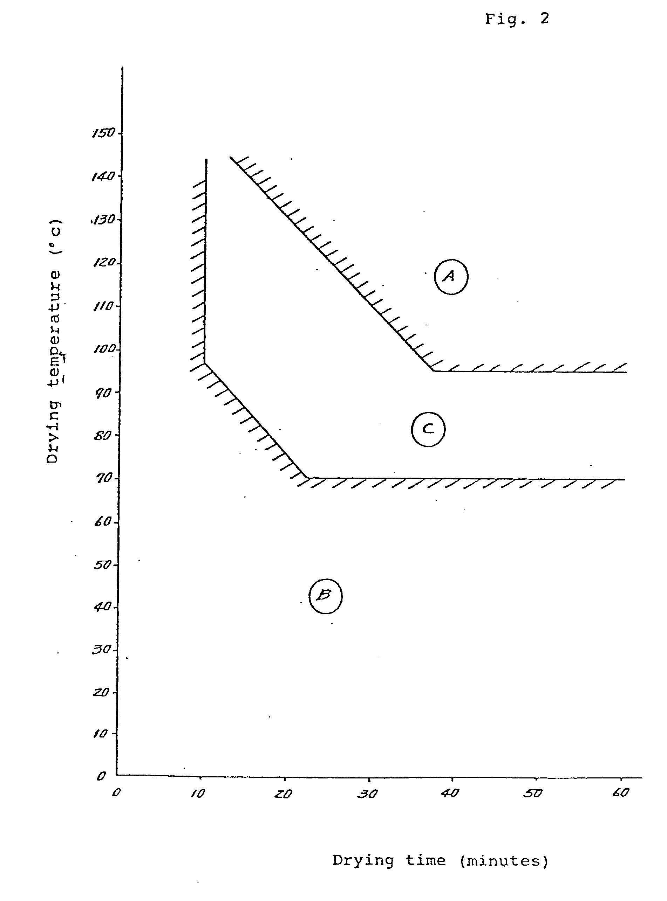

A part of the experimental results pertaining to this drying temperature condition are illustrated in Figures 2 to 5. In each Figure, the vertical axis represents drying temperature (°C), while the horizontal axis represents drying period (minutes). A portion A indicates an over-drying area where the organic binder is hardened such that elimination of paste film by dissolving the paste film is difficult. A portion B indicates an under-drying area where hardening is insufficient and coating of the photo-resist is difficult. A portion C indicates an adequate drying area where the paste film can be removed easily and the resist film can be coated without deformation.

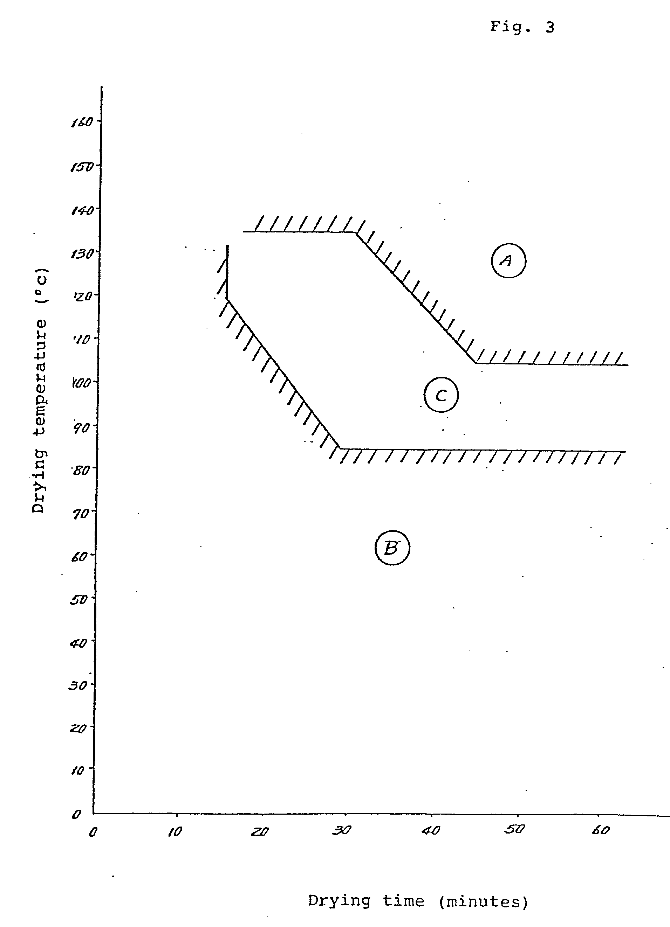

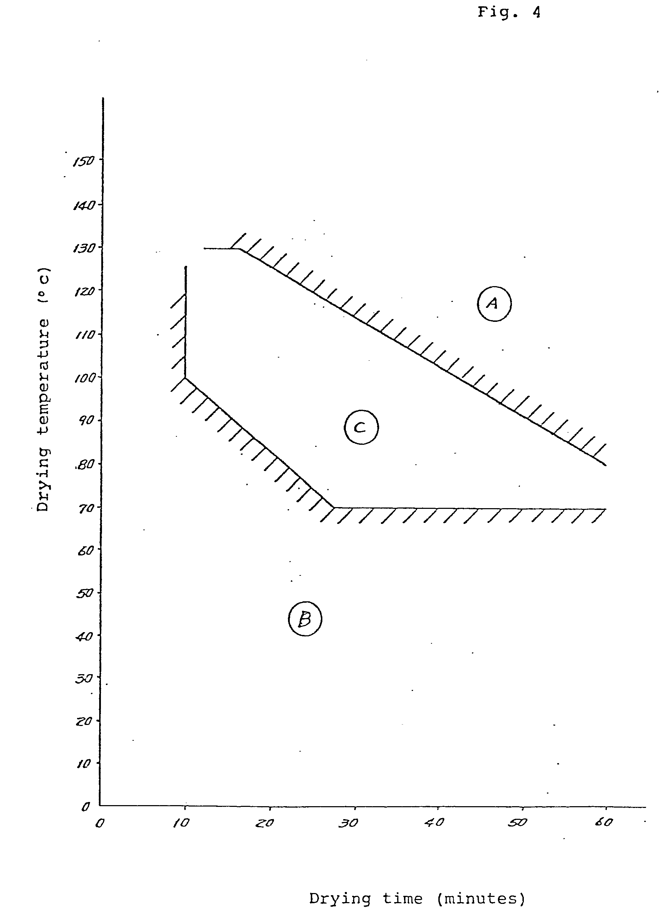

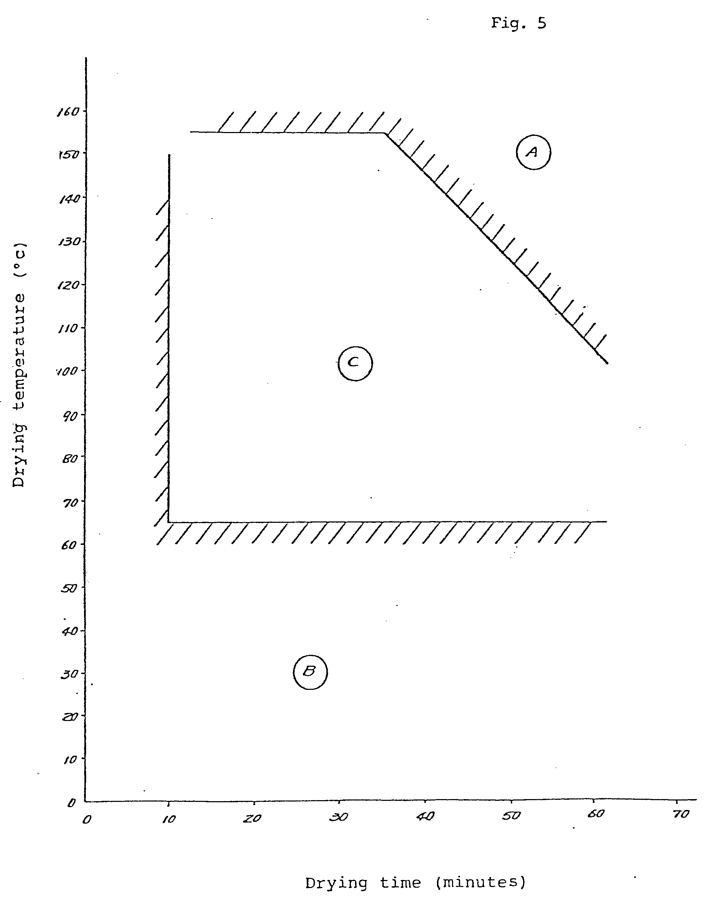

Figure 2 illustrates the drying temperature condition for Au conductor paste (du Pont brand "Dp9260"). Figure 3 illustrates that of Au conductor paste (Shoei Chemical brand "4405G"). Figure 4 illustrates that of insulation paste (du Pont brand "DP9429"), and Figure 5 illustrates that of insulation paste (Shoei Chemical brand "51728").

For the experimental results, 1,1,1-trichloroethane was used as organic solvent for removing paste film by dissolving the paste and the organic solvent was sprayed on. Formation of photo-resist film on paste film was effected by the following process. Namely, water soluble resist liquid (Fuji Yakuhin brand "Fujiron 20") is sprayed on to the substrate which is being rotated at a rate of 500 rpm by a spinner and thereby the resist film can be coated and formed to a thickness of several $\mu$m (1 to 4 $\mu$m).

As is understood from the above experimental results, drying temperature and drying period conditions for circuit forming paste can be summarised as follows. The adequate drying temperature should be within the range from 60°C to 160°C, and the drying time should be 10 minutes or longer, but not more than 60 minutes having regard to production time and production efficiency.

Experiments have been carried out for various pastes other than the abovementioned conductor paste and insulation paste and for resistance paste and dielectric paste, and these also proved that the above-mentioned drying conditions were adequate.

Further experiments have been performed to determine what kind of photo-resist is adequate for obtaining a fine pattern. The inventors conducted such experiments for various kinds of photo-resists now obtainable on the market and have proved that a water soluble resist not including organic solvent is very effective for formation of a fine pattern.

The following Table 1 shows some of the photo-resists experimentally used.

TABLE 1

| No. | Photo-resist (brand) | | Maker |
|---|---|---|---|
| 1 | AZ-111 | positive type | Shiplay |
| 2 | OMR | negative type | Tokyo Applied Chemical |
| 3 | AZ-1350 | positive type | Shiplay |
| 4 | KPR | negative type | Kodak |
| 5 | OSR | negative type | Tokyo Applied Chemical |
| 6 | Photo ink | negative type | Tokyo Applied Chemical |
| 7 | Fujiron D20 | negative type | Fuji Yakuhin |

In the case of photo-resists No. 1 to No. 6 in the above table being used, formation of a fine pattern is difficult and formation of circuit pattern using paste film is impossible. However, when photo-resist No. 7 is used, fine and excellent circuit pattern can be formed.

An explanation for this will be developed in concrete terms. Photo-resists No. 2, No. 4, No. 5 and No. 6 are negative type resists and a resist pattern cannot be formed because paste film below the resist is floated off or peeled off simultaneously at the time of development of the photo-resist. On the other hand, when the photo-resists No. 1 and No. 3 are used, the resist pattern can be formed by development but the circuit pattern cannot be formed since the resists are positive type and a water soluble developer is used as developer.

The reason is that these photoresists (No. 1 to No. 6) contain an organic solvent such as Cellosolve-acetate, ("Cellosolve" is a Régistered Trade Mark) organic amine, xylene, butyl acetate and ketone and thereby the photo-resist film is formed in such a condition that the organic solvent pentrates into the dried paste film. Moreover, since No. 2, No. 4, No. 5 and No. 6 photo-resists use an organic solvent for which the paste is easily dissolved into the developer particularly, the paste film itself is dissolved into the developer at the time of developing. In addition, in the case of photoresists No. 1, 3, since the developer is water soluble type, resist penetrated into the paste film cannot be removed and simultaneously since the photo-resist film is liable to be dissolved into the organic solvent (for example, 1,1,1-trichloroethane etc). which is used for removing unwanted paste film, a circuit pattern cannot be formed at all.

On the other hand, photo-resist No. 7 is a water soluble photo-resist which can be obtained by adding a diazo compound to aqueous solution obtained when polyvinyl alcohol (PVA) powder is dipped into water and then heated for dissolution purposes. The photo-resist thus obtained does not contain any organic solvent and water is used as developer.

Therefore, when photo-resist No. 7 is used, the paste film is never influenced by the photo-resist and the developer, and it also has a solvent resistible characteristic and thereby a circuit pattern seems to be formed which has a pattern width almost equal to that of the exposed and developed photo-resist pattern.

Moreover, the paste is oleaginous including organic solvent as explained above, while the water soluble resist is aqueous, and the paste and resist have different properties because of this.

Thus, the water soluble resist and developer (water) little penetrate into the paste even if it is in the drying condition. This also seems to be the factor ensuring formation of excellent circuit patterns.

Experiments using several other kinds of photo-resists not including an organic solvent (for example, a water soluble resist of casein and the sodium dichromate family) proved that a satisfactory circuit pattern can be formed as in the case of photo-resist No. 7.

Then, concerning a means for removing the dried paste film by dissolving it, as illustrated in Figure 1(D), every organic solvent such as 1,1,1-trichloroethane which can dissolve a thick film paste can be used, and a method wherein the organic solvent is sprayed on to the exposed area of the paste film with the substrate being rotated is very effective.

Other organic solvents used in experiments for comparison purposes are acetone, terpineol isopropyl alcohol, ethyl alcohol, xylene, butyl acetate, Cellosolve-acetate and trichloroethylene, and these are all excellent. From these results, the recommended organic solvents should be those which are not poisonous, do not carry a fire hazard risk and are easy to handle.

When a substrate is only dipped into such organic solvent, good workability cannot be obtained since a longer time is taken for removal of the paste film, and it is difficult to obtain a fine pattern since side etching of the circuit pattern becomes large. On the other hand, in the abovementioned organic solvent spraying method, the organic resin in the paste is forcibly removed and the mixed powder is splashed away. Thereby the working efficiency is excellent and a fine pattern having sharp edges can be obtained very easily. In addition, when the organic solvent is sprayed on to the substrate rotating at a rate of 1000 rpm, the dissolved paste (organic resin, mixed powder) is automatically splashed to the outside by centrifugal force, thus improving workability.

The desirable spraying pressure of organic solvent is 3 kg/cm$^2$ to 20 kg/cm$^2$ when paste film dried up at a temperature from 60°C to 160°C is removed by means of 1,1,1-trichloroethane, because if the spraying pressure is 2 kg/cm$^2$ or less, longer time is taken for removal, while if it is 21 kg/cm$^2$ or more, there is a danger that the circuit pattern may be deformed or disconnected.

The adoption of a method as described above to a product will be explained hereunder.

Table 2 indicates adoption in relation to a hybrid IC. In this table, I indicates a formation condition in which a straight wiring conductor having a pattern width of 50 $\mu$m and a pattern space of 80 $\mu$m is formed on an insulated substrate by the method of Figure 1, while II indicates a formation condition in which a resistance element having a pattern width of 50 $\mu$m and a pattern space of 80 $\mu$m is formed on an insulated substrate by the method of Figure 1.

The wiring conductor and resistance element thus obtained show electrical characteristics similar to those obtained with the same pattern width and space formed by a thin film forming method and can be used practically.

## TABLE 2

| | I | II |
|---|---|---|
| Substrate | Alumina ceramic substrate | Alumina ceramic substrate |
| Paste | Ruthenium oxide DP1431 | Au-paste DP9260 |
| Paste thickness | 20 $\mu$m | 15 $\mu$m |
| Drying condition | 70°C, 15 minutes | 120°C, 15 minutes |
| Photo-resist | Fujiron D20 PVA family | Fujiron D20 PVA family |
| Organic solvent | 1,1,1-trichloroethane | 1,1,1-trichloroethane |
| Spraying pressure | 5 kg/cm$^2$ | 10 kg/cm$^2$ |
| Baking temperature | 870°C, 15 minutes | 850°C, 15 minutes |

Table 3 indicates adoption in relation to a plasma display. The formation condition is that a discharge electrode pattern of a meander form having a pattern width of 60 $\mu$m and a spacing of 60 $\mu$m is formed on a glass substrate. A plasma display having such electrode pattern shows electrical characteristics similar to those of a plasma display manufactured by a thin film forming method and brightness is also excellent for practical use.

5

**0 016 231**

TABLE 3

| Substrate | Soda glass substrate |
|---|---|
| Paste | Au paste "#4423" |
| Paste thickness | 10 $\mu$m |
| Drying conditions | 110°C, 10 minutes |
| Photo-resist | "Fujiron 20" PVA family |
| Organic solvent | 1,1,1-trichloroethane |
| Spraying pressure | 15 kg/cm$^2$ |
| Baking temperature | 580°C, 40 minutes |

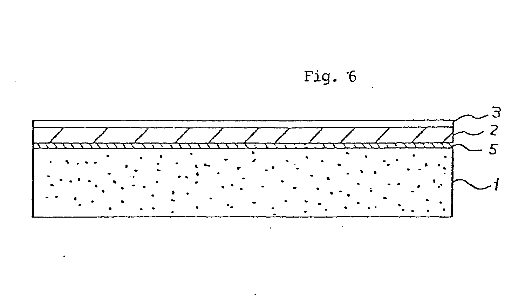

Figure 6 illustrates an embodiment of this invention. In the method embodying this invention, a bonding layer 5 consisting of thermoplastic resin is formed first on the substrate 1, the paste film 2 is formed by coating circuit formation paste on the bonding layer 5, and then a circuit film can be obtained by patterning the paste film 2 with water soluble photo-resist as explained above.

As the bonding layer 5, a thermoplastic resin having a softening point lower than the drying temperature is used. For example, epoxy resin which is hardened at a normal temperature, "Epicoat 1004" etc. is adequate. Also wax etc. is adequate.

Existence of such a bonding layer reinforces contact between the paste film 2 and substrate 1 and thereby does not easily allow pattern deviation or deformation during spraying of organic solvent. Thus, a finer pattern (40 $\mu$m or less) can be formed.

In addition, the surface of the dry paste film 2 is uneven to a considerable extent and therefore the surface of water soluble resist formed on the paste film also becomes uneven, thus making the mask contact non-uniform during exposure. For this reason, a so-called "circuit pattern having sharp edge" cannot be obtained easily.

Here, the surface of paste film 2 is made smooth by brushing with a glass fibre brush etc. and thereafter the water soluble resist film is formed on the paste film surface. This is very effective for obtaining a finer circuit pattern.

According to this invention, as explained above, a fine pattern having an accuracy similar to that of a circuit pattern obtained by the thin film forming method can be obtained by the thick film forming method, and moreover this method is economical and it is easy to produce a circuit pattern as compared with the thin film forming method.

The circuit pattern, in addition, obtained by this invention shows electrical characteristics similar to those provided by the existing thin film forming method which are sufficient for practical use.

It is also possible to use water soluble resist film, coated and formed on the paste film by the thermal bonding method.

## Claims

1. A method of forming a thick film fine pattern, in which an oleaginous thick film paste icluding an organic solvent is used for circuit formation and in which an aqueous photo-resist not including an organic solvent is used for patterning the paste, the photo-resist being coated on the paste surface, after coating of the paste on a substrate and drying of the paste, and exposed and developed, thereafter uncovered paste being removed by spraying with organic solvent, and remaining paste baked, characterised in that a bonding agent is coated on the substrate and the paste is coated on the substrate over the bonding agent.

2. A method as claimed in claim 1, wherein the bonding agent is composed of a thermoplastic resin having a softening point below the drying temperature of the thick film paste.

3. A method as claimed in claim 1 or 2, wherein the surface of the paste film is smoothed under a drying condition when formed on the bonding layer.

4. A method as claimed in claim 1, wherein the substrate is rotated whilst uncovered paste is removed by spraying with organic solvent.

5. A method as claimed in claim 4, wherein the organic solvent is sprayed at a pressure in the range of 3 kg/cm$^2$ to 20 kg/cm$^2$.

6. A thick film hybrid IC, formed by a method as claimed in any preceding claim.

7. A plasma display, formed by a method as claimed in any preceding claim.

## Revendications

1. Procédé de formation d'un motif fin en pellicule épaisse, dans lequel une pâte en pellicule épaisse oléagineuse comportant un solvant organique est utilisée pour la formation du circuit et dans lequel un vernis photorésistant aqueux ne comportant pas de solvant organique est utilisé pour tracer le motif sur la pâte, le vernis photorésistant étant déposé à la surface de la pâte, après dépôt de la pâte sur un substrat et séchage de la pâte, et étant exposé et développé, après quoi la pâte non recouverte est enlevée par pulvérisation à l'aide d'un solvant organique, et la pâte restante est cuite, caractérisé en ce qu'on dépose un agent liant sur le substrat et on dépose la pâte sur le substrat pardessus l'agent liant.

6

**0 016 231**

2. Procédé selon la revendication 1, où l'agent liant est constitué d'une résine thermoplastique possédant un point de ramollissement inférieur à la température de séchage de la pâte en pellicule épaisse.

3. Procédé selon la revendication 1 ou 2, où on rend régulière la surface de la pellicule de pâte dans des conditions de séchage lorsqu'on la forme sur la couche liante.

4. Procédé selon la revendication 1, où on entraîne en rotation le substrate pendant qu'on enlève la pâte non recouverter par pulvérisation à l'aide d'un solvant organique.

5. Procédé selon la revendication 4, où on pulvérise le solvant organique à une pression comprise dans l'intervalle de 3 kg/cm² à 20 kg/cm².

6. Circuit intégré hybride en pellicule épaisse, formé par un procédé tel que revendiqué dans une quelconque précédente recevendication.

7. Dispositif d'affichage à plasma, formé par un procédé tel que revendiqué dans l'une quelconque précédents revendication.

**Patentansprüche**

1. Verfahren zur Herstellung feiner Dickfilmmuster, bei welchem eine ölige, dicke Filmpaste, welche ein organisches Lösungsmittel enthält, zur Schaltungsbildung verwendet wird und bei welchem ein wäßriger Fotoresist, welcher kein organisches Lösungsmittel enthält, zum Mustern der Paste verwendet wird, wobei der Fotoresist, nach Aufbringen der Paste auf ein Substrat und nach Trocknen der Paste, auf die Pastenoberfläche aufgebracht und dann belichtet und entwickelt wird, woraufhin unbedeckte Paste durch Besprühung mit einem organischen Lösungsmittel entfernt und die verbleibende Paste gebacken wird, dadurch gekennzeichnet, daß ein Bindungsagens als Überzug auf dem Substrat aufgebracht und die Paste als Überzug auf dem Substrat über dem Bindungsagens aufgebracht wird.

2. Verfahren nach Anspruch 1, dadurch gekennzeichnet, daß das Bindungsagens aus thermoplastischen Harz besteht und einen Erweichungspunkt unterhalb der Trockentemperatur der Dickfilmpaste hat.

3. Verfahren nach Anspruch 1 oder 2, dadurch gekennzeichnet, daß die Oberfläche des Pastenfilms, wenn er auf der Bindungsschicht gebildet wird, unter Trocknungsbedingungen geglättet wird.

4. Verfahren nach Anspruch 1, dadurch gekennzeichnet, daß das Substrat rotiert wird, während die unbedeckte Paste durch Besprühen mit organischem Lösungemittel entfernt wird.

5. Verfahren nach Anspruch 4, dadurch gekennzeichnet, daß das organische Lösungsmittel mit einem Druck im Bereich zwischen 3 kg/cm² bis 20 kg/cm² gesprüht wird.

6. Integrierte Dickfilm-Hybridschaltung, hergestellt nach einem Verfahren nach einem der vorhergehenden Ansprüche.

7. Plasmaanzeige, hergestellt nach einem Verfahren nach einem der vorhergehenden Ansprüche.

7

Fig. 1

(A)

(B)

(C)

(D)

(E)

Fig. 2

Drying time (minutes)

Fig. 3

Fig. 4

Fig. 5

Drying time (minutes)

Fig. 6